# FASCICULE DE BREVET EUROPEEN

(11) **EP 2 122 704 B1**
(45) Date de publication et mention de la délivrance du brevet: **24.11.2010**
(21) Numéro de dépôt: 08717713.5
(22) Date de dépôt: 12.03.2008
(51) Int. Cl.: H01L 45/00, G11C 16/02

(54) **UTILISATION DE SPINELLES LACUNAIRES A AGREGATS TETRAEDRIQUES D'ELEMENT DE TRANSITION DU TYPE AM4X8 DANS UNE MEMOIRE NON VOLATILE REINSCRIPTIBLE DE DONNEES ELECTRONIQUES, ET MATERIAU CORRESPONDANT.**
VERWENDUNG VON LACUNARSPINELLEN MIT TETRAEDRISCHEN AGGREGATEN EINES ÜBERGANGSELEMENTS DES AM4X8-TYPS IN EINEM MEHRMALS BESCHREIBBAREN NICHTFLÜCHTIGEN SPEICHER FÜR ELEKTRONISCHE DATEN UND ENTSPRECHENDES MATERIAL
USE OF LACUNAR SPINELS WITH TETRAHEDRAL AGGREGATES OF A TRANSITION ELEMENT OF THE OF THE AM4X8 TYPE IN AN ELECTRONIC DATA REWRITABLE NON VOLATILE MEMORY, AND CORRESPONDING MATERIAL

(30) Priorité: 14.03.2007 FR 0701819
(43) Date de publication de la demande: 25.11.2009
(73) Titulaire: Université de Nantes, 44035 Nantes Cedex 1 (FR)
(72) Inventeur: CARIO, Laurent, F-44200 Nantes (FR); CORRAZE, Benoît, F-44470 Carquefou (FR); JANOD, Etienne, F-44240 La Chapelle Sur Erdre (FR); VAJU, George Christian, 1022 Chavannes près Renens (CH); BESLAND, Marie-Paule, F-44700 Orvault (FR)
(74) Mandataire: Larcher, Dominique
(86) Numéro de dépôt international: PCT/EP2008/052968
(87) Numéro de publication internationale: WO 2008/113734

(56) Documents cités:
- US-A1- 2005 029 587
- SHANTHI N ET AL: "Electronic structure of vacancy ordered spinels, GaMo4S8 and GaV4S8, from ab initio calculations" JOURNAL OF SOLID STATE CHEMISTRY ACADEMIC PRESS USA, vol. 148, no. 1, 15 novembre 1999 (1999-11-15), pages 143-149, XP002454878 ISSN: 0022-4596
- ABD-ELMEGUID M M ET AL: "Transition from Mott insulator to Superconductor in GaNb4Se8 and GaTa4Se8 under high pressure" PHYSICAL REVIEW LETTERS APS USA, vol. 93, no. 12, 17 septembre 2004 (2004-09-17), pages 126403/1-4, XP002454879 ISSN: 0031-9007
- CHUDO ET AL: "Magnetic and structural transitions of GeV4S8" PHYSICA B. CONDENSED MATTER, AMSTERDAM, NL, vol. 378-380, 1 mai 2006 (2006-05-01), pages 1150-1151, XP005431885 ISSN: 0921-4526
- Zeitschrift fur Anorganische und Allgemeine Chemie Huthig-Johann Ambrosius Barth Verlag Germany, vol. 624, no. 6, juin 1998 (1998-06), pages 952-958, XP002454880 ISSN: 0044-2313

## Description

Le domaine de l'invention est celui des mémoires non volatiles de données électroniques. Plus précisément, l'invention concerne un composé formant le matériau actif d'une mémoire non volatile réinscriptible de données électroniques, en particulier pour le stockage de données informatiques.

La technologie actuelle des mémoires non-volatiles est dominée par les mémoires "flash" qui sont utilisées dans toutes les applications grand public (appareils photo numériques, clés USB, etc).

Ces mémoires "flash" présentent des obstacles quant à leur miniaturisation, ces obstacles étant notamment liés à :
- leur tenue limitée en cyclage ;
- les temps d'écriture élevé (> 10 µs) ;
- les fortes tensions nécessaires (> 10 V).

Récemment, les mémoires RRAM (Resistive Random Access Memory) sont apparues comme une solution alternative.

En effet, les mémoires RRAM égalent les mémoires "flash" en termes de densité et de coût, tout en étant plus rapide et en consommant moins.

Dans les systèmes RRAM, des impulsions électriques très courtes (100 ns) génèrent une variation de la résistance facilement mesurable (Rₕₐᵤₜ » R_{bas}) d'un simple dispositif constitué de deux électrodes séparées par un matériau actif.

Actuellement, on connaît plusieurs types de matériaux actifs pour RRAM parmi lesquels :
- PrCaMnO (ou PCMO), plus connu sous le nom de "CMR" (Colossal Magnetic Resistance) ;
- NiO ;
- Cu₂O ;
- TiO₂.

Pour les mémoires de type TiO₂, une couche de TiO₂ est placée entre deux électrodes. Des filaments sont créés dans le matériau reliant les deux électrodes et permettent de conduire le courant (résistance faible). En appliquant une tension sur le côté positif, une partie des filaments est oxydée, ce qui accroît la résistance du matériau. Inversement, par effet Joule, on réduit le côté positif des filaments afin de réduire la résistance à nouveau.

Les RRAM présentent un potentiel très important pour leurs applications au domaine du stockage de données informatiques, mais sont toutefois actuellement seulement au stade de prototypes de laboratoire et sont donc en cours d'expérimentation.

Certaines données sont donc manquantes quant à leur développement à un niveau industriel.

L'invention a notamment pour objectif de proposer un nouveau type de RRAM.

Plus précisément, l'invention a pour objectif de proposer un matériau utilisable comme matériau actif d'une mémoire non volatile réinscriptible de données électroniques et/ou informatiques, qui présentent de réelles perspectives d'exploitation industrielle.

En ce sens, l'invention a notamment pour objectif de fournir un matériau qui permette de :
- faire commuter un élément logique entre deux états de résistance électrique avec de faibles tensions, préférentiellement inférieures à 0,1 V ;
- obtenir des temps de commutation entre deux états inférieurs à ceux des mémoires de type "flash" de l'art antérieur ;
- augmenter l'intégration, c'est-à-dire d'augmenter la quantité d'information stockée par unité de volume.

Ces objectifs, ainsi que d'autres qui apparaîtront par la suite, sont atteints grâce à l'invention qui concerne l'utilisation d'un matériau appartenant à la famille des spinelles lacunaires à agrégats tétraédriques d'élément de transition AM₄X₈ comme matériau actif d'une mémoire non volatile réinscriptible de données électroniques, dans lequel :
- A comprend l'un au moins des éléments suivants : Ga, Ge, Zn;
- M comprend l'un au moins des éléments suivants : V, Nb, Ta, Mo ;
- X comprend l'un au moins des éléments suivants : S, Se.

Dans le cadre d'études effectuées sur des composés présentant des non-linéarités courant-tension, la Demanderesse a en effet découvert de façon surprenante l'existence d'un phénomène de transition résistive non-volatile induite par impulsions électriques dans la famille de spinelles lacunaires à agrégats tétraédriques d'élément de transition AM₄X₈.

N Shanti et D D Sarma, J. Solid State Chem. 148 (199), p. 143-149, M M Abd-Elmeguid et al., Phys. Rev. Lett. 93 (2004), p. 126403/1-4 et H Chudo et al., Physica B 378-390 (2006), p. 1150-1151 décrivent des matériaux appartenant à la famille des spinelles d'élément de transition AM₄X₈ dans lesquels A comprend l'un des éléments Ga ou Ge, M l'un des éléments V, Nb, Ta ou Mo et X l'un des éléments S ou Se.

Des monocristaux de ces composés ont été synthétisés et, après dépôt d'électrodes métalliques, l'application d'impulsions électriques permet de faire varier la résistance de manière non volatile et réversible de ces matériaux : il est ainsi possible de cycler à température ambiante entre deux états de haute et de basse résistance. Ce cycle peut être répété de manière reproductible et cet effet peut être utilisé pour réaliser une mémoire non volatile réinscriptible.

Les caractéristiques observées permettent d'envisager des applications industrielles de l'utilisation de ces matériaux comme matériau actif dans des mémoires de type RRAM.

En effet, comme cela va être montré par la suite, un matériau utilisé selon l'invention présente les avantages de :
- commuter entre deux états de résistance électrique avec de faibles tensions, inférieures à 0,1 V ;
- obtenir des temps de commutation entre deux états inférieurs à ceux des mémoires de type "flash" ;
- augmenter l'intégration, c'est-à-dire d'augmenter la quantité d'information stockée par unité de volume.

On note qu'on entend par "matériau actif" dans le cadre de l'invention un matériau susceptible de présenter deux états distincts, en particulier résistifs, sous application d'impulsions électriques.

Selon une application préférentielle, ledit matériau est placé entre deux électrodes métalliques, ledit matériau entre lesdites deux électrodes métalliques formant avantageusement un bit d'information binaire.

Une telle structure permet ainsi de constituer un bit d'information possédant deux états, l'un de haute résistance et l'autre de basse résistance pouvant être considérés comme des 0 et 1 logiques, permettant ainsi de stocker l'information dans la logique binaire classiquement utilisée dans le domaine des mémoires informatiques.

De plus, une telle structure contribue à augmenter la quantité d'informations stockée par unité de volume, la géométrie d'une telle structure étant notablement plus simple que celle utilisée dans les mémoires "flash", ce qui permet de réduire la taille de chaque bit.

Par ailleurs, selon une approche avantageuse de l'invention :
- A = Ga_{1-x-y}GeₓZn_{y}, où 0 ≤ x + y ≤ 1, avec 0 ≤ x ≤ 1 et 0 ≤ y≤ 1 ;
- M = V_{1-α-β-γ}Nb_{α}Ta_{β}Mo_{γ}, où 0 ≤ α + β + γ ≤ 1, avec 0 ≤ α ≤ 1, 0≤ β≤ 1 et 0 ≤ γ≤ 1 ;
- X = S_{1-ν}Se_{ν}, où 0≤ ν≤ 1.

Selon différents modes de réalisation avantageux :
- x = 0, y =0, β = 1, ν = 1;
- x = 0, y = 0, α = 0, β = 0, γ = 0, ν = 0;
- x = 0, y = 0, α = 1, ν = 1 ;
- x = 0, y =0, α = 0, β =0, γ =0, ν = 1;
- x = 1, α = 0, β = 0, γ =0, ν = 0.

D'autres caractéristiques et avantages de l'invention apparaîtront plus clairement à la lecture de la description suivante de plusieurs modes de réalisation de l'invention, donnés à titre d'exemples illustratifs et non limitatifs, et des dessins annexés parmi lesquels :
- les figures 1 et 2 sont chacune une vue d'un schéma de connexion électrique aux sources de courants et voltmètres de monocristaux d'un matériau selon l'invention, respectivement en mode "deux contacts" et en mode "quatre contacts" ;
- la figure 3 est une représentation schématique d'un composant formant bit d'information et incluant un matériau actif selon l'invention ;

- la figure 4 est une illustration du protocole utilisé pour faire commuter un matériau selon l'invention ;
- la figure 5 est un graphique des courbes de mesure obtenues avec le protocole illustré par la figure 4 ;
- la figure 6 est un graphique de courbes de mesures réalisées sur un matériau selon l'invention, illustrant un cyclage entre les états initial et transité du matériau ;
- la figure 7 est un graphique de courbes de mesures réalisées sur un matériau selon l'invention, illustrant différents états de basse résistance mesurés après application de différentes impulsions électriques ;
- la figure 8 est un graphique de modélisation des mesures de la figure 7 ;
- la figure 9 est une représentation schématique d'un modèle à deux conductances utilisé pour modéliser les mesures illustrées par la figure 8 ;
- les figures 10 à 16 sont des graphiques de mesures de l'effet d'Electro-Résistance Colossale (CER) non-volatile réalisées sur différents matériaux selon l'invention.

Tel qu'indiqué précédemment, le principe de l'invention réside dans l'utilisation d'un matériau appartenant à la famille des spinelles lacunaires à agrégats tétraédriques d'élément de transition AM₄X₈ comme matériau actif d'une mémoire non volatile réinscriptible de données électroniques.

Plus précisément, A, M et X sont caractérisés de la façon suivante :
- A comprend l'un au moins des éléments suivants : Ga, Ge, Zn;
- M comprend l'un au moins des éléments suivants : V, Nb, Ta, Mo;
- X comprend l'un au moins des éléments suivants : S, Se.

Au cours des dernières années, un travail de recherche a été engagé par la Demanderesse dans le domaine des matériaux présentant de fortes non-linéarités électriques courant-tension.

Ces effets de non-linéarités électriques courant-tension ont été mis en évidence à basse température dans le composé incommensurable 2D (LaS)_{1.195}VS₂, avec une chute de résistivité de plus de cinq ordres de grandeurs (effet CER).

Cependant, malgré la présence d'hystérésis, aucun effet non-volatile n'est observé dans (LaS)_{1.195}VS₂.

Structuralement, ce composé se caractérise par une modulation inhabituelle des distances V-V : les plus courtes définissent des fragments clusterisés de vanadium.

Par ailleurs, des travaux réalisés parallèlement ont montré que ce composé est proche de l'état isolant de Mott.

Aussi, en faisant l'hypothèse d'un lien possible entre l'effet CER, la proximité de l'état isolant de Mott et l'existence d'agrégats triangulaires de vanadium, les propriétés du composé GaV₄S₈ ont été explorées. Cette spinelle lacunaire possède des tétraèdres de vanadium réguliers et isolés les uns des autres.

L'existence d'un effet CER dans ce composé a été découvert.

Mais fait plus remarquable, la Demanderesse a découvert que cet effet CER est non-volatile.

Les différents travaux mettant en évidence les propriétés de ces matériaux sont décrits ci-après.

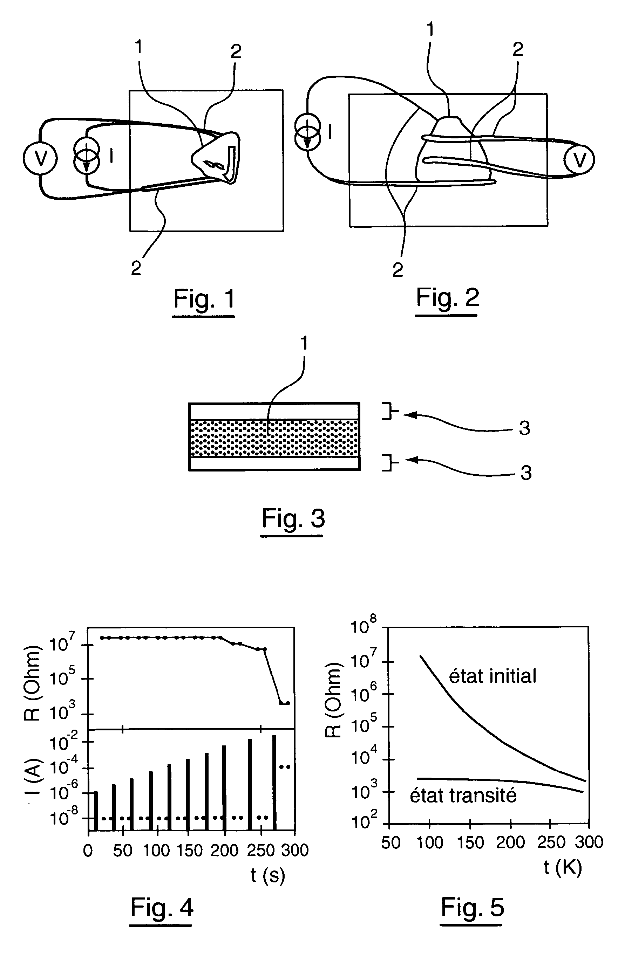

En référence aux figures 1 et 2, des monocristaux 1 des composés isostructuraux AM₄X₈ de dimensions typiques 300 µm × 300 µm × 300 µm ont été synthétisés.

Des électrodes d'argent, d'or ou de carbone 2 ont ensuite été posées sur ces monocristaux 1 afin de réaliser des connexions électriques à une source de courant et à un voltmètre.

Le dispositif ainsi obtenu fonctionne en mode « deux contacts » (Figure 1). Le mode « quatre contacts » (figure 2) a été également réalisé afin de vérifier que la propriété de commutation est intrinsèque au matériau et n'est pas liée à un effet d'interface entre les électrodes et le matériau.

Une variante préférentielle pour l'application de l'invention au domaine de la microélectronique concerne le dépôt en couche mince (dont l'épaisseur est de l'ordre de quelques centaines de nm) des matériaux AM₄X₈. Une géométrie pertinente est de type "MIM" (métal-isolant-métal) dans laquelle le matériau AM₄X₈ est pris en sandwich entre deux électrodes métalliques 3 (figure 3).

On note qu'ainsi constitué, le composant peut avantageusement constituer un bit d'information possédant deux états, l'un de haute résistance et l'autre de basse résistance pouvant être considérés comme des 0 et 1 logiques, permettant ainsi de stocker l'information en logique binaire.

Une série d'impulsions électriques d'intensité I croissante a été appliquée à un échantillon, la résistance électrique R de celui-ci ayant été mesurée après chaque impulsion, ceci en appliquant le protocole illustrée par la figure 4.

Ce protocole a pour but de faire commuter l'échantillon d'un état de haute résistance (≈ 30 MΩ) vers un état de basse résistance (≈ 3 kΩ).

La mesure a été effectuée à 85 K en mode « quatre contacts » (figure 2) sur le composé GaV₄S₈.

La figure 5 est un relevé de mesures de la résistance électrique de l'échantillon en fonction de la température dans l'état initial de haute résistance et dans l'état transité de basse résistance.

On remarque donc que pour des impulsions de faible intensité (entre 1 µA et 3 mA), la résistance mesurée après impulsion (≈ 30 MΩ) ne varie pas (transition volatile).

En revanche, à partir d'une intensité seuil, la résistance électrique de GaV₄S₈ mesurée après impulsion chute brusquement à 3 kΩ.

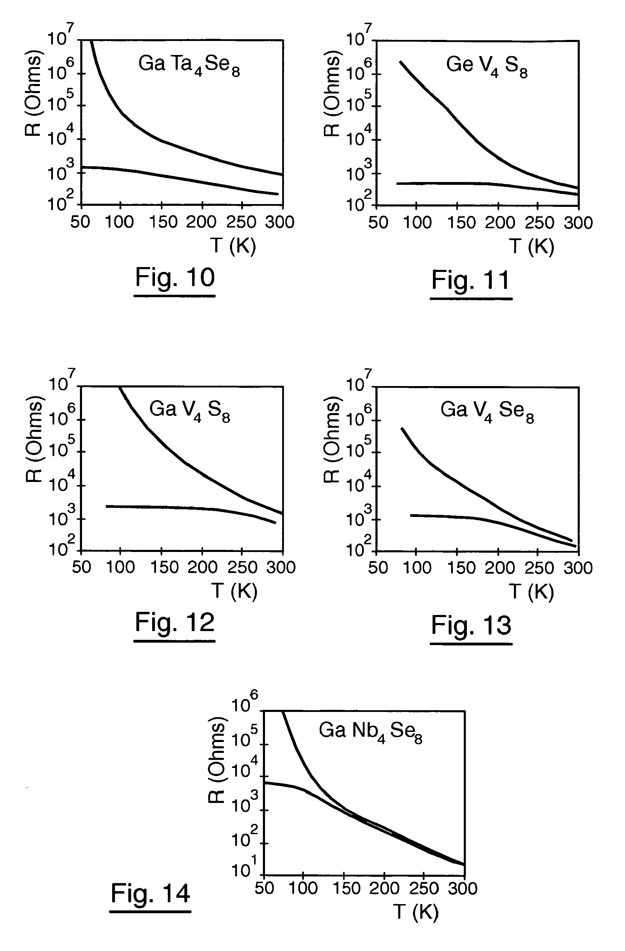

Ce comportement non-volatile, dont l'observation était inattendue à l'origine des travaux de recherche, apparaît aussi bien dans GaV₄S₈ que dans GaTa₄Se₈, GeV₄S₈, GaV₄Se₈ et GaNb₄Se₈, comme le montrent les figures 10 à 14.

L'état transité de basse résistance est non-volatile et garde ses propriétés sur plusieurs heures : il a en effet été observé que la courbe de résistance de l'état transité était reproductible à la montée et à la descente en température.

On note que les valeurs de x, y, α, β, y, ν peuvent prendre des valeurs intermédiaires entre 0 et 1.

Ainsi, pour l'élément A de AM₄X₈, celui-ci peut se présenter sous la forme :
- Ga_{0,95} Zn_{0,05}, avec par exemple M=Ta et X = Se,
- Ga₁₋ₓ Geₓ, (avec x égal à environ 0,02), avec par exemple M=Ta et X = Se

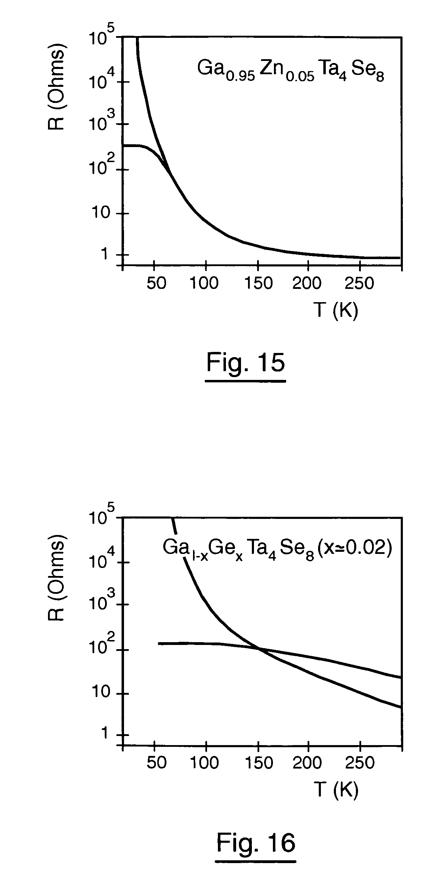

Les figures 15 et 16 montrent le comportement non volatile de ces matériaux.

On note de plus que d'autres variantes de réalisation du matériau AM₄X₈ peuvent être envisagées, celui-ci pouvant être défini plus largement de la façon suivante :
- A = Ga_{1-x-y}GeₓZn_{y}, où 0 ≤ x + y ≤ 1, avec 0 ≤ x ≤ et 0 ≤ y≤ 1;
- M = V_{1-α-β-γ}Nb_{α}Ta_{β}Mo_{γ}, où 0 ≤ α + β +γ ≤ 1, avec 0 ≤ α ≤ 1, 0≤ β≤ 1 et 0 ≤ γ≤ 1 ;
- X = S_{1-ν}Se_{ν}, où 0 ≤ ν≤ 1.

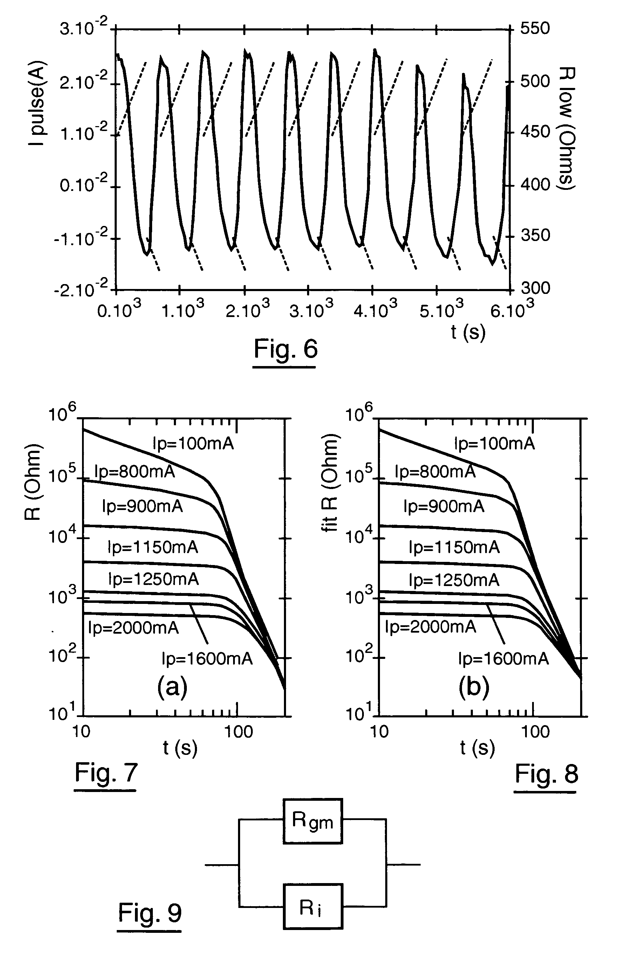

La figure 6 montre qu'il est possible de cycler à température ambiante entre états de haute et de basse résistance.

Après avoir fait chuter la résistance électrique d'un échantillon de GaV₄Se₈ sous l'effet d'impulsions d'intensité croissante (entre 10 et 24 mA), le sens du courant des impulsions suivantes a été inversé (entre -10 et -17 mA). La résistance électrique remonte alors pour revenir à la haute résistance initiale.

Ce cycle a été répété plusieurs fois avec une bonne reproductibilité comme le montre clairement la figure 6.

Comme le montre la figure 5, l'état « transité » de basse résistance possède une nature différente de l'état initial de haute résistance.

En particulier, les dépendances en température de la résistance dans les deux états sont très différentes.

La dépendance en température de la résistance dans l'état initial est caractéristique d'un isolant avec des énergies d'activation d'environ 0.1 eV.

Pour l'état transité, on observe une dépendance caractéristique d'un isolant à haute température puis, pour des températures inférieures à 100K (variable selon l'échantillon), une résistance variant très faiblement en température.

Ce changement de comportement suggère un transport électrique par deux fluides, et les données obtenues précédemment ont été modélisés à partir d'un modèle à deux conductances illustré schématiquement par la figure 9.

Ce modèle consiste en un circuit parallèle composé d'une part d'une résistance de type isolante Rᵢ et d'autre part d'une résistance type métal granulaire Rgₘ.

La figure 8 montre que les courbes expérimentales illustrées par la figure 7, qui montre différents états de basse résistance mesurés après application d'impulsions d'intensité croissante allant de 100 mA à 2A sur un cristal du composé GaTa₄Se₈, ont été reproduites de façon très satisfaisante à partir de ce modèle.

Ce modèle indique donc que les impulsions électriques génèrent une séparation de phase électronique avec création/réorganisation d'îlots métalliques baignés dans une matrice isolante.

## Revendications

1. Utilisation d'un matériau appartenant à la famille des spinelles lacunaires à agrégats tétraédriques d'élément de transition AM₄X₈ comme matériau actif d'une mémoire non volatile réinscriptible de données électroniques, dans lequel :
- A comprend l'un au moins des éléments suivants : Ga, Ge, Zn ;
- M comprend l'un au moins des éléments suivants : V, Nb, Ta, Mo ;
- X comprend l'un au moins des éléments suivants : S, Se.

2. Utilisation d'un matériau selon la revendication 1, **caractérisée en ce que** ledit matériau est placé entre deux électrodes métalliques.

3. Utilisation d'un matériau selon la revendication 2, **caractérisée en ce que** ledit matériau entre lesdites deux électrodes métalliques forme un bit d'information binaire.

4. Utilisation d'un matériau selon l'une quelconque des revendications 1 à 3, **caractérisée en ce que** :
- A = Ga_{1-x-y}GeₓZn_{y}, où 0 ≤ x + y ≤ 1, avec 0 ≤ x ≤ et 0 ≤ y≤ 1;
- M V_{1-α-β-γ}Nb_{α}Ta_{β}Mo_{γ}, où 0 ≤ α + β +γ ≤ 1, avec 0 ≤ α ≤ 1, 0≤ β≤ 1 et 0 ≤ γ≤ 1 ;
- X = S_{1-ν}Se_{ν}, où 0 ≤ ν≤ 1.

5. Utilisation d'un matériau selon la revendication 4, **caractérisée en ce que** x = 0, y = 0, β = 1, ν = 1.

6. Utilisation d'un matériau selon la revendication 4, **caractérisée en ce que** x = 0, y = 0, α = 0, β = 0, γ = 0, ν = 0.

7. Utilisation d'un matériau selon la revendication 4, **caractérisée en ce que** x = 0, y = 0, α = 1, ν = 1.

8. Utilisation d'un matériau selon la revendication 4, **caractérisée en ce que** x = 0, y = 0, α = 0, β = 0, γ = 0, ν = 1.

9. Utilisation d'un matériau selon la revendication 4, **caractérisée en ce que** x = 1, α = 0, β = 0, γ = 0, ν = 0.

## Claims

1. Use of a material belonging to the family of lacunar spinels with tetrahedral aggregates of a transition element AM₄X₈ as an active material of an electronic data rewritable non-volatile memory, wherein:
- A comprises at least one of the following elements: Ga, Ge, Zn;
- M comprises at least one of the following elements: V, Nb, Ta, Mo;
- X comprises at least one of the following elements: S, Se.

2. Use of a material according to claim 1, **characterised in that** the material is placed between two metal electrodes.

3. Use of a material according to claim 2, **characterised in that** the material between the two metal electrodes forms a binary information bit.

4. Use of a material according to any one of claims 1 to 3, **characterised in that**:
- A = Ga_{1-x-y}GeₓZn_{y}, where 0 ≤ x + y ≤ 1, with 0 ≤ x ≤ and 0 ≤ y 1;
- M = V_{1-α-β-γ}Nb_{α}Ta_{ß}Mo_{γ}, where 0 ≤ α+β+γ ≤ 1, with 0 ≤ α ≤ 1, 0 ≤ β ≤ 1 and 0 ≤ γ ≤ 1;
- X = S₁₋ᵥSeᵥ, where 0 ≤ v ≤ 1.

5. Use of a material according to claim 4, **characterised in that**
x = 0, y = 0, β = 1, v = 1.

6. Use of a material according to claim 4, **characterised in that**
x = 0, y = 0, α = 0, β = 0, γ = 0, v = 0.

7. Use of a material according to claim 4, **characterised in that**
x = 0, y = 0, α = 1, v = 1.

8. Use of a material according to claim 4, **characterised in that**
x = 0, y = 0, α = 0, β = 0, γ - 0, v = 1.

9. Use of a material according to claim 4, **characterised in that**
x = 1, α = 0, β = 0, γ = 0, v = 0.

## Patentansprüche

1. Verwendung eines Materials zugehörig zu der Familie der lückenhaften Spinelle mit tetraedrischen Aggregaten eines Übergangselementes AM₄X₈ als aktives Material eines nicht-flüchtigen, wiederbeschreibbaren Speichers für elektronische Daten, in dem:
- A mindestens eines der folgenden Elemente umfasst: Ga, Ge, Zn;
- M mindestens eines der folgenden Elemente umfasst: V, Nb, Ta, Mo;
- X mindestens eines der folgenden Elemente umfasst: S, Se.

2. Verwendung eines Materials gemäß Anspruch 1, **dadurch gekennzeichnet, dass** das Material zwischen zwei metallischen Elektroden platziert ist.

3. Verwendung eines Materials gemäß Anspruch 2, **dadurch gekennzeichnet, dass** das Material zwischen den beiden metallischen Elektroden ein Bit binärer Information bildet.

4. Verwendung eines Materials gemäß irgendeinem der Ansprüche 1 bis 3, **dadurch gekennzeichnet, dass**:
- A = Ga_{1-x-y}GeₓZn_{y}, wo 0 ≤ x + y ≤ 1, mit 0 ≤ x ≤ und 0 ≤ y ≤ 1;
- M = V_{1-α-β-γ}Nb_{α}Ta_{ß}MO_{γ}, wo 0 ≤ α + β + γ ≤ 1, mit 0 ≤ α ≤ 1, 0 ≤ β ≤ 1 und 0 ≤ γ ≤ 1;
- X = S₁₋ᵥSeᵥ, wo 0 ≤ v ≤ 1.

5. Verwendung eines Materials gemäß Anspruch 4, **dadurch gekennzeichnet, dass** x = 0, y = 0, β = 1, v = 1.

6. Verwendung eines Materials gemäß Anspruch 4, **dadurch gekennzeichnet, dass** x = 0, y = 0, α = 0, β = 0, γ = 0, v = 0.

7. Verwendung eines Materials gemäß Anspruch 4, **dadurch gekennzeichnet, dass** x = 0, y = 0, α = 1, v = 1.

8. Verwendung eines Materials gemäß Anspruch 4, **dadurch gekennzeichnet, dass** x = 0, y = 0, α = 0, β = 0, γ = 0, v = 1.

9. Verwendung eines Materials gemäß Anspruch 4, **dadurch gekennzeichnet, dass** x = 1, α = 0, β = 0, γ = 0, v = 0.
